# EUROPÄISCHE PATENTSCHRIFT

(11) **EP 1 507 943 B1**
(45) Veröffentlichungstag und Bekanntmachung des Hinweises auf die Patenterteilung: **25.07.2007**
(21) Anmeldenummer: 03732360.7
(22) Anmeldetag: 13.05.2003
(51) Int. Cl.: E05B 65/12, B60R 25/00, H03K 17/96

(54) **SCHLÜSSELLOSE SICHERHEITS- /BETÄTIGUNGSEINRICHTUNG FUR KRAFTFAHRZEUGE**
KEY-LESS SECURITY/ACTUATION DEVICE FOR MOTOR VEHICLES
DISPOSITIF DE SECURITE ET D'ACTIONNEMENT SANS CLE POUR DES VEHICULES AUTOMOBILES

(30) Priorität: 14.05.2002 DE 10221511
(43) Veröffentlichungstag der Anmeldung: 23.02.2005
(73) Patentinhaber: Kiekert Aktiengesellschaft, 42579 Heiligenhaus (DE)
(72) Erfinder: VAN GASTEL, Peter, 42699 Solingen (DE)
(86) Internationale Anmeldenummer: PCT/EP2003/004986
(87) Internationale Veröffentlichungsnummer: WO 2003/095776

(56) Entgegenhaltungen:
- EP-A- 1 187 346
- DE-A- 4 218 798
- DE-A- 10 051 055
- FR-A- 2 833 986

## Beschreibung

Die Erfindung betrifft eine schlüssellose Sicherheits-/Betätigungseinrichtung für Kraftfahrzeuge, mit einer kraftfahrzeugseitigen Sende-/Empfangseinheit sowie einem bedienerseitigen Datenträger, und mit zumindest einem Sensor, welcher einen Dialog zwischen,der Sende-/Empfangseinheit und dem Datenträger zur Darstellung von Bedienfunktionen initiiert.

Bei diesen Bedienfunktionen handelt es sich beispielsweise um das Ver- und/oder Entriegeln einzelner oder aller Kraftfahrzeugtürverschlüsse. Ebenso kann hiermit das Schließen oder Öffnen von Fenstern und/oder des Schiebedachs bzw. Verdecks gemeint sein. Zu den Bedienfunktionen gehören auch das Öffnen oder Schließen eines Daches bei einem Cabriolet. Ebenso Sitzverstellungen, eine Tankent-/-verriegelung und vergleichbare Funktionen, die gemeinsam oder nach bestimmten Ablaufschemata in Abhängigkeit von einem oder mehreren aus dem Datenaustausch abgeleiteten Befehlen durchgeführt werden.

Im Rahmen der DE 42 18 798 A1 wird eine schlüsselgebundene Schließanlage für Verschlüsse an Türen und Klappen eines Fahrzeuges beschrieben. Neben einer Zentralverriegelung für die Türen lässt sich gleichzeitig auch eine sogenannte "Komfortschließung" darstellen. Das geschieht durch eine ununterbrochene, länger andauernde Betätigung eines Handsenders bzw. elektronischen Schlüssels oder mittels eines mechanischen Schlüssels, welcher länger als eine bestimmte Zeitdauer in Verriegelungsstellung gehalten wird.

Der gattungsbildende Stand der Technik nach der EP 0 954 098 A2, von dem die Erfindung ausgeht, betrifft ein Erkennungssystem mit einem Leiter, welcher Bestandteil eines Kondensators mit variabler, von der Nähe einer Person abhängigen Kapazität ist. Ein Detektor dient zur Erfassung von Veränderungen in der Kapazität und zum Erzeugen eines Ausgangssignals. Das Ausgangssignal registriert Annäherungen einer Person relativ zu dem vorgenannten Leiter.

Zusätzlich ist ein Schalter vorgesehen, welcher ergänzend oder alternativ die Nähe der Person anzeigt. Dadurch wird eine kapazitive Annäherungserfassung bei gleichzeitiger Bereitstellung des mechanischen Schalters als Reserve für den Fall, dass die kapazitive Erfassung der Veränderung in der Kapazität versagt, zur Verfügung gestellt. So oder so lässt sich mit Hilfe der beiden Sensoren nur ein und dieselbe Bedienfunktion initiieren.

Zum gattungsbildenden Stand der Technik gehört auch ein Kraftfahrzeug-Türschließsystem gemäß der DE 100 07 500 A1, In diesem Fall sorgt eine Annäherung einer Bedienperson und/oder eine Berührung eines Türaußengriffs dafür, dass entweder Reflexionen von ausgesandten elektromagnetischen Wellen und/oder Änderungen der elektrischen Kapazität einer Antenne detektiert und zum Starten der Datenabfrage des Datenträgers ausgewertet werden.

Bekanntermaßen verfügt der bedienerseitige Datenträger über benutzerspezifische und zumeist abgespeicherte Werte, die bei dem ablaufenden Datenaustausch zwischen der Sende-/Empfangseinheit und dem Datenträger abgeglichen und überprüft werden und erst bei positivem Ergebnis zur Freigabe beispielsweise des Kraftfahrzeugtürverschlusses und/oder anderer Bedienfunktionen führen.

Aus der DE 100 51 055 A1 ist eine Vorrichtung zum Einleiten eines Öffnungs- und Verriegelungsvorgangs eines Kraftfahrzeuges bekannt mit jeweils einer Annäherungssensorik zum Erzeugen eines Signals zum Entriegeln und Verriegeln des Schließsystems.

Der Stand der Technik ist zum einen aufwendig (vgl. DE 42 18 798 A1) genügt zum anderen heutigen Komfortanforderungen nicht (mehr).

Auch können manchmal Fehlauslösungen der Bedienfunktionen nicht ausgeschlossen werden, wenn beispielsweise nicht eine Hand an den Sensor angenähert wird, sondern sich der Bediener schlicht und ergreifend an ein Fahrzeug anlehnt und so für den Start der Datenabfrage sorgt. Hier will die Erfindung Abhilfe schaffen.

Der Erfindung liegt das technische Problem zugrunde, eine schlüssellose Sicherheits-/Betätigungseinrichtung für Kraftfahrzeuge der eingangs beschriebenen Ausgestaltung so weiter zu entwickeln, dass der Datenaustausch auf einfache und eindeutige Art und Weise gestartet wird und ungewünschte Bedienfunktionen nicht versehentlich ausgelöst werden.

Zur Lösung dieser technischen Problemstellung ist eine gattungsgemäße schlüssellose Sicherheits-/Betätigungseinrichtung für Kraftfahrzeuge im Rahmen einer ersten Variante dadurch gekennzeichnet, dass wenigstens drei Sensoren vorgesehen sind, welche je nach dem Zeitmuster ihrer Beaufschlagung unterschiedliche Bedienfunktionen einleiten. Bei den Sensoren handelt es sich üblicherweise um kapazitive Sensoren, die auf Annäherungen und/oder Berührungen reagieren, wie dies beispielhaft in der EP 0 954 098 A2 beschrieben wird.

Im Rahmen eines zweiten selbständigen Alternativvorschlages ist bei einer gattungsgemäßen schlüssellosen Sicherheits-/Betätigungseinrichtung für Kraftfahrzeuge vorgesehen, dass wenigstens drei Sensoren realisiert sind, wobei im Anschluss an die Beaufschlagung des einen Sensors ein anderer oder die anderen Sensoren unmittelbar oder mit einstellbarer Verzögerung wirkungslos geschaltet werden.

Dadurch lassen sich auf einfache Weise von den jeweiligen Sensoren ausgelöste verschiedene Bedienfunktionen unmittelbar voneinander separieren. Denn sobald der eine Sensor beispielsweise eine Annäherung detektiert hat und hieraus die damit zusammenhängende Bedienfunktion resultiert, können die anderen Sensoren wirkungslos geschaltet werden, um die hiervon abweichende und mit diesem Sensor verbundene Bedienfunktion zu blockieren. Auf diese Weise können die im Anschluss an den Datenaustausch eingeleiteten Bedienfunktionen eineindeutig festgelegt werden, so dass es nicht zu Überschneidungen, Doppeltauslösungen, Fehlauslösungen etc. kommt.

Dennoch lassen sich auch in diesem Fall - wie bei der erstgenannten Lösung mit dem abgefragten Zeitmuster bei der Beaufschlagung der Sensoren - mindestens zwei Sensoren von ihrer Funktionsweise her kombinieren. Das gilt besonders für den Fall, dass nach Beaufschlagung des einen Sensors ein oder die anderen Sensoren erst nach einer einstellbaren Verzögerungszeit wirkungslos geschaltet werden. Dadurch ist eine gemeinsame Abfrage innerhalb des mit der Verzögerungszeit geschaffenen Zeitfensters möglich bevor der einer der Sensoren wirkungslos wird.

Auf diese Weise lassen sich die Sensoren gemeinsam und zeitlich hintereinander zur Realisierung verschiedener Bedienfunktionen einsetzen. Beispielsweise mag die erstmalige Betätigung des einen Sensors und darauffolgende Beaufschlagung des anderen Sensors zu einer bestimmten Bedienfunktion, beispielsweise einem Komfortöffnen, führen, während die umgekehrte Vorgehensweise beispielsweise ein Komfortschließen einleitet. Mit dem Begriff "Komfortöffnen" ist gemeint, dass unter anderem das Verdeck eines Cabriolets geöffnet wird. Zusätzlich können im Rahmen einer solchen Komfortöffnung auch noch weitere bedienerspezifische Funktionen eingeleitet werden, die eine Abfrage des Datenträgers erfordern, was beim Verdecköffnen bzw. -schließen nicht unbedingt nötig ist.

Alternativ oder zusätzlich ist es auch denkbar, die Sensoren im Wechsel zur Darstellung einer oder mehrerer gewünschter Bedienfunktionen zu beaufschlagen. Selbstverständlich können die beiden Sensoren auch gemeinsam sowie gleichzeitig eine Beaufschlagung erfordern, was wiederum zu einer anderen Bedienfunktion führt.

In der Regel sind die Sensoren an eine Auswerteschaltung angeschlossen, welche zwischen jeweiligen Beaufschlagungsroutinen unterscheidet und gegebenenfalls in Abhängigkeit hiervon wenigstens einen Sensor mit oder ohne Zeitverzögerung vorgegebener Größe wirkungslos schaltet und/oder die jeweils gewünschte Bedienfunktion unterstützt. Das heißt, die Auswerteschaltung übernimmt letztlich die Steuerung der Sensoren bzw. deren Spannungsbeaufschlagung (bei kapazitiven Sensoren) und auch die Auswertung von Näherungs- und/oder Berührungssignalen. Auch gibt die Auswerteschaltung regelmäßig einen Detektions- und/oder Auslösebereich jedes einzelnen Sensors vor. Auf diese Weise kann die Auswerteschaltung zwischen den verschiedenen und zuvor erläuterten Betriebszuständen exakt unterscheiden.

Dazu gehört die Beaufschlagung eines Sensors und als Resultat hiervon eine erste Bedienfunktion. Die alternative Auslösung eines anderen Sensors mag zu einer zweiten Bedienunktion führen. Wenn zunächst der erste und dann der zweite Sensor eine Beaufschlagung erfahren, mag hieraus eine dritte Bedienfunktion resultieren. Die umgekehrte vorgehensweise gehört zu einer vierten Bedienfunktion. Eine fünfte Bedienfunktion kann dadurch realisiert werden, dass beide Sensoren gleichzeitig ausgelöst werden.

Selbstverständlich sind auch noch mehr als fünf realisierbare Bedienfunktionen mit bereits zwei Sensoren denkbar, und zwar dann, wenn auch noch unterschiedliche Zeitabfolgen zwischen der Auslösung des ersten und des zweiten Sensors ins Kalkül gezogen werden. So kann beispielsweise zwischen einem langen und einem kurzen Zeitintervall bei der Betätigungsabfrage: erster Sensor - zweiter Sensor unterschieden werden usw.. Hierauf wird man in der Praxis jedoch zumeist verzichten, um die Bedienung nicht zu verkomplizieren.

Werden erfindungsgemäß wenigstens drei Sensoren verwirklicht, wird die Anzahl der einleitbaren Bedienfunktionen noch einmal deutlich erhöht. Zwei von ihnen formen als Koppelsensoren eine Betätigungseinheit, während der dritte Sensor einen Einzelsensor darstellt.

In diesem Fall dienen die beiden Koppelsensoren beispielhaft dazu, im Sinne einer "ODER"-Verknüpfung ein Verriegelungssignal für angeschlossene Kraftfahrzeugtürverschlüsse zu erzeugen. Dieses liegt also vor, wenn entweder der eine oder der andere oder beide Koppelsensoren eine Beaufschlagung erfahren.

Zusätzlich kann mit diesen Koppelsensoren eine Komfortöffnung und Komfortschließung realisiert werden, indem zuerst der eine Sensor und dann der andere Sensor ausgelöst wird (Komfortöffnung) oder die umgekehrte Vorgehensweise zur Komfortschließung führt. Dagegen dient der Einzelsensor überwiegend dazu, den Kraftfahrzeugtürverschluss oder die Kraftfahrzeugtürverschlüsse zu entriegeln.

Damit sowohl die Komfortöffnung als auch die Komfortschließung eindeutig dargestellt werden können, werden die jeweils nicht beaufschlagten Sensoren erst nach einem von der Auswerteschaltung vorgegebenen Zeitintervall wirkungslos geschaltet. Dieses Zeitintervall entspricht einem Zeitraum, welcher beim Überstreichen erst des einen und dann des anderen Sensors üblicherweise abläuft (ca. 0,5 bis 1 Sekunde).

Alternativ kann auch mit drei Einzelsensoren eine Komfortöffnung und Komfortschließung realisiert werden, indem immer nur ein Sensor ausgelöst wird. In diesem Fall dient ein erster Sensor dazu, den Kraftfahrzeugtürverschluss oder die Kraftfahrzeugtürverschlüsse zu entriegeln, ein zweiter Sensor, der vorzugsweise in zwei miteinander verbundene Sensorflächen aufgeteilt ist, dient der Verriegelung dieser und ein dritter Sensor steuert das Komfortschließen an.

Die Sensoren sind zumeist an exponierter Stelle außenseitig des Kraftfahrzeuges angeordnet, um auf Annäherungen der Bedienperson zuverlässig reagieren zu können. So empfiehlt die Erfindung beispielsweise deren Platzierung im oder am Türaußengriff. Grundsätzlich ist es aber auch denkbar, die Sensoren beispielsweise im Blinkergehäuse, im Außenspiegelgehäuse, in der Antenne usw. unterzubringen,

Schließlich handelt es sich bei den Sensoren üblicherweise um Näherungs- oder Berührungssensoren mit vorgegebenem

Detektions- und Auslösebereich, wie mit Bezug zu der Figurenbeschreibung noch näher erläutert wird.

Im Ergebnis wird eine schlüssellose Sicherheits-/Betätigungseinrichtung für Kraftfahrzeuge zur Verfügung gestellt, die die von einem Nutzer jeweils gewünschte Bedienfunktion eindeutig festlegt. Der Ablauf oder das Auslösen verschiedener, zum Teil nicht gewünschter Funktionen entfällt also.

Hinzu kommt, dass sich mit wenigstens drei Sensoren je nach Auslöseschema ganz unterschiedliche Bedienfunktionen darstellen lassen, so dass der Komfort gegenüber dem Stand der Technik enorm gesteigert ist. Hierin sind die wesentlichen Vorteile zu sehen.

Im Folgenden wird die Erfindung anhand einer lediglich ein Ausführungsbeispiel darstellenden Zeichnuzng näher erläutert; es zeigen:
- Fig. 1: eine schematische Darstellung der Betätigungseinrichtung in Aufsicht beim Auslösen der Bedienfunktion "Entriegeln",
- Fig. 2: die Betätigungseinrichtung nach Fig. 1 beim Auslösen der Bedienfunktion "Verriegeln",
- Fig. 3: den Gegenstand nach den Fig. 1 und 2 vereinfacht beim Auslösen der Bedienfunktion "Komfortöffnen",
- Fig. 4: den Gegenstand nach Fig. 3 beim "Komfortschließen",
- Fig. 5: den Gegenstand nach den Fig. 1 bis 3 in schematischem Querschnitt mit den jeweiligen Detektionsbereichen der Sensoren,
- Fig. 6: den Gegenstand nach Fig. 5 beim Auslösen der Funktionen "Verriegeln", " Komfortschließen " und "Komfortöffnen",
- Fig. 7: den Gegenstand nach Fig. 6 beim Auslösen der Bedienfunktion "Entriegeln",
- Fig. 8: eine schematische Darstellung der Betätigungseinrichtung mit drei Einzelsensoren in Aufsicht beim Auslösen der Bedienfunktion " Komfortschließen ".

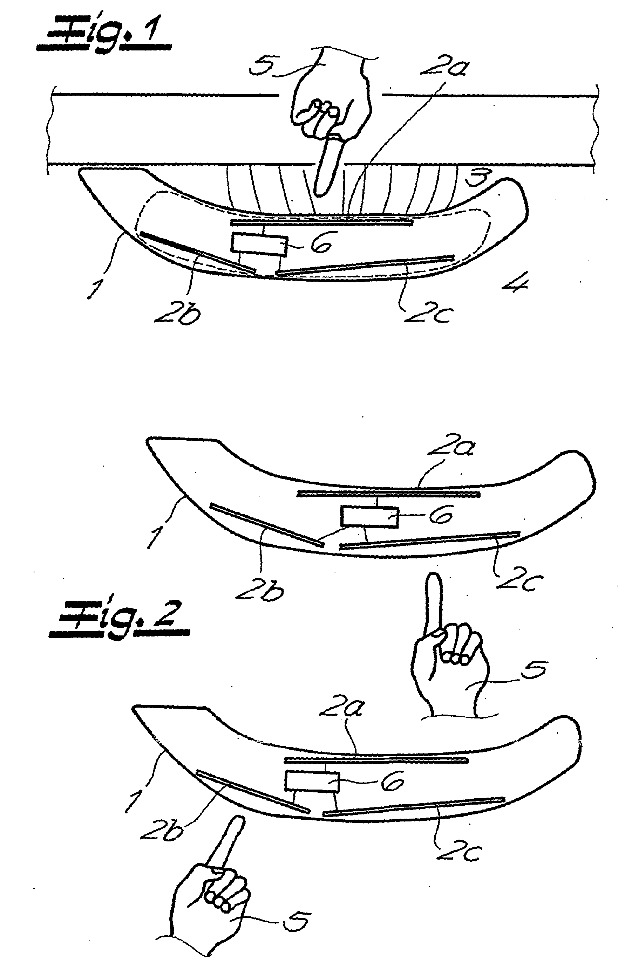

In den Figuren 1 bis 7 ist eine schlüssellose Sicherheits-/Betätigungseinrichtung für Kraftfahrzeuge dargestellt. Man erkennt einen Türaußengriff 1 aus vorzugsweise Kunststoff, welcher in seinem Innern drei Sensoren 2a, 2b, 2c aufnimmt. Zwei Sensoren 2b, 2c sind als Koppelsensoren 2b, 2c ausgeführt und formen eine Betätigungseinheit 2b, 2c. Bei dem dritten Sensor 2a handelt es sich um einen Einzelsensor 2a.

Der Einzelsensor 2a ist an der dem Kraftfahrzeug zugewandten Seite 3 des Türaußengriffs 1 positioniert, während sich die beiden Koppelsensoren 2b, 2c an der dem Kraftfahrzeug abgewandten Seite 4 des Türaußengriffs 1 finden.

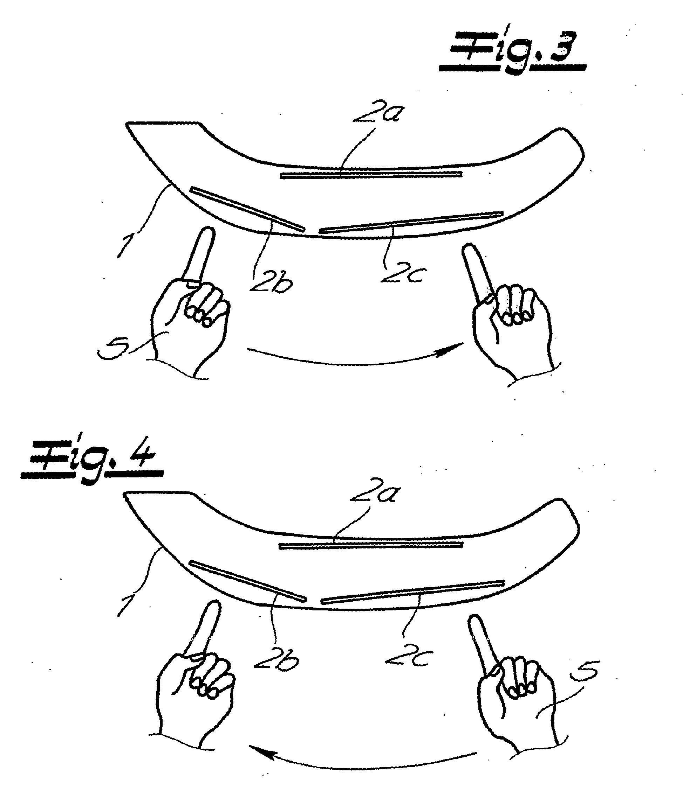

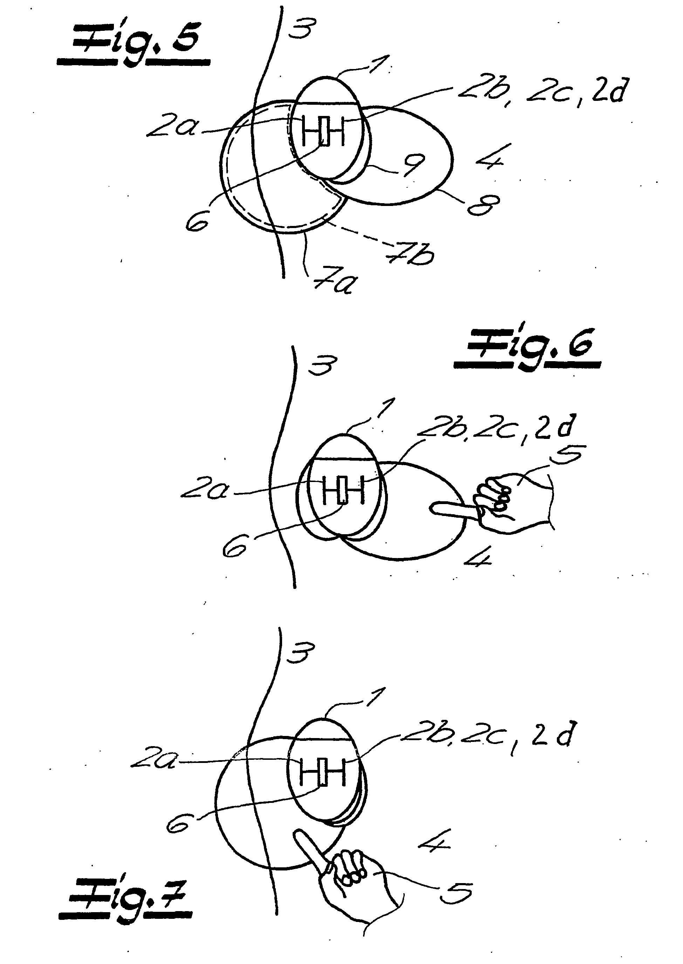

Sämtliche dargestellten Sensoren 2a, 2b, 2c arbeiten kapazitiv und verfügen jeweils über eine besonders in den Fig. 3 und 4 erkennbare Elektrode, die zusammen mit einem Gegenstand 5, z. B. einer menschlichen Hand 5, einen jeweiligen Kondensator 2a, 5; 2b, 5 und 2c, 5 formen. Annäherungen und/oder Berührungen der menschlichen Hand 5 korrespondieren zu Kepazitätsänderungen eines oder mehrerer dieser Kondensatoren 2a, 5; 2b, 5 und 2c, 5, die mit Hilfe einer den Sensoren 2a, 2b und 2c gemeinsamen Auswerteschaltung 6 erfasst und in Bedienfunktionen umgesetzt werden. Das ist im Zusammenhang mit jeweils einem auf diese Weise gebildeten Kondensator 2a, 5; 2b, 5; 2c, 5 grundsätzlich bekannt, wozu auf die EP 0 954 098 A2 verwiesen sei.

Der Sensor bzw. Einzelsensor 2a verfügt über einen Detektionsbereich 7a und einen Auslösebereich 7b (vgl. Fig. 5). Demgegenüber ist der Detektionsbereich bei den Sensoren bzw. Koppelsensoren 2b, 2c mit 8 bezeichnet, während der Auslösebereich das Bezugszeichen 9 trägt.

Unter dem Detektionsbereich 7a bzw. 8 ist im Rahmen der Erfindung der Bereich des zugehörigen Sensors 2a, 2b, 2c zu verstehen, innerhalb dessen Annäherungen des Gegenstandes 5 erkannt werden. Das heißt, sobald die menschliche Hand 5 in das hiermit verbundene elektrische Feld der zugehörigen Elektrode des Sensors 2a, 2b, 2c eintritt, führt dies zu Kapazitätsänderungen, die von der Auswerteschaltung 6 registriert werden. Demgegenüber führt das Eindringen der Hand 5 in den Auslösebereich 7b bzw. 9 dazu, dass der zugehörige Sensor 2a, 2b, 2c tatsächlich auch ausgelöst wird und nicht nur die Annäherung der Hand 5 als solche erkennt.

Hierdurch werden die Sensoren 2a, 2b, 2c in einerseits Berührungssensoren 2b, 2c andererseits einen Näherungssensor 2a unterteilt. Bei den Berührungssensoren 2b, 2c nimmt der Auslösebereich 9 nur einen geringen Teil des Detektionsbereiches 8 ein. Das heißt, die Hand 5 muss nahezu an den Sensor 2b, 2c herangeführt werden, um diesen auszulösen. Dagegen decken sich beim Näherungssensor 2a Detektionsbereich 7a und Auslösebereich 7b im Wesentlichen, so dass bereits Annäherungen den Sensor 2a auslösen (vgl. Fig. 5 bis 7).

Die Unterscheidung zwischen den Detektionsbereichen 7a, 8 und den Auslösebereichen 7b, 9 ermöglicht, dass beim Eindringen der Hand 5 in den Detektionsbereich 7b, 8 des zugehörigen Sensors 2a, 2b, 2c die jeweils verbleibenden Sensoren 2a, 2b, 2c unmittelbar oder mit einstellbarer Verzögerung wirkungslos geschaltet werden (können).

Im Rahmen des Ausführungsbeispiels hat der Detektionsbereich 8 der Koppelsensoren 2b bzw. 2c die Aufgabe, den Sensor 2a zu deaktivieren. Auf diese Weise wird sichergestellt, dass die zum "Verriegeln", "Komfortöffnen" und "Komfortschließen " eingesetzten Sensoren 2b, 2c nicht von etwaigen Annäherungen der Hand 5 an den Sensor 2a beeinflusst werden, der zum "Entriegeln" dient.

Man erkennt, dass die beiden vorgenannten Sensoren 2b, 2c alternativ zur Darstellung einer oder mehrerer gewünschter Bedienfunktionen beaufschlagbar sind. So lässt sich der Zustand "Verriegelung" der Kraftfahrzeugtürverschlüsse dadurch einstellen, dass einer der beiden Sensoren 2b, 2c (oder beide) ausgelöst werden, indem die Hand 5 in den zugehörigen Auslösebereich 9 eindringt, wie dies insbesondere in den Fig. 5 und 6 sowie 2 dargestellt ist. Zuvor hat jedoch das Passieren des Detektionsbereiches 8 dafür gesorgt, dass der Sensor 2a wirkungslos geschaltet worden ist, und zwar nach einer von der Auswerteschaltung 6 vorgegebenen Zeitspanne. Dadurch sind nun nur noch die Sensoren 2b, 2c aktiv, um die Bedienfunktionen "Verriegeln", "Komfortöffnen" oder "Komfortschließen" einleiten zu können. Eine unbeabsichtigte Entriegelung ist nicht möglich.

Nachdem einer der Sensoren 2b, 2c (oder auch 2a) ausgelöst worden ist, findet ein Frage-/Antwortdialog zwischen einer nicht ausdrücklich dargestellten kraftfahrzeugseitigen Sende-/Empfangseinheit sowie einem bedienerseitigen Datenträger statt. Nach positivem Vergleich der auf dem Datenträger abgelegten nutzerspezifischen Daten und dem in der kraftfahrzeugseitigen Sende-/Empfangseinheit hinterlegten Code wird ein Signal an die zentralverriegelung weitergegeben, die Kraftfahrzeugtürverschlüsse in diesem Fall zu verriegeln (oder zu entriegeln). Selbstverständlich können auch andere Bedienfunktionen im Anschluss hieran ausgelöst werden, wie dies eingangs bereits beschrieben wurde.

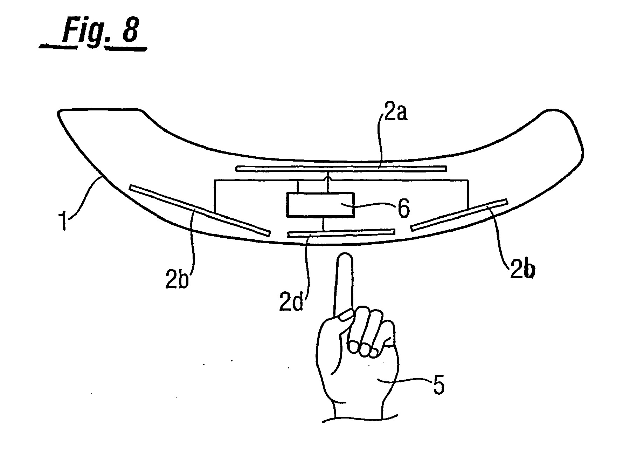

Der prinzipiell gleiche Vorgang wird durchlaufen, wenn anstelle der Sensoren 2b, 2c der Sensor 2a eine Annäherung durch die Hand 5 erfährt. Das ist insbesondere in Fig. 7 dargestellt. Dabei decken sich der Detektionsbereich 7a und der Auslösebereich 7b des vorzugsweise als Näherungssensor ausgeführten Einzelsensors 2a. Auf diese Weise sorgt die in den Detektions-/Auslösebereich 7a, 7b eindringende Hand 5 unmittelbar dafür, dass die verbleibenden Sensoren 2b, 2c (nach einer vorgegebenen Zeitspanne) wirkungslos geschaltet werden und hierdurch nur noch die gewünschte Bedienfunktion "Entriegeln" vollzogen werden kann.

Neben der zuvor erläuterten grundsätzlichen Bedienfunktion "Verriegeln" können die Sensoren 2b und 2c zur Darstellung der Funktionen "Komfortöffnen" und "Komfortschließen" auch zeitlich hintereinander ausgelöst werden. Dabei lässt sich je nach Zeitabfolge bzw. Zeitmuster der Beaufschlagung der beiden Sensoren 2b, 2c zwischen unterschiedlichen Bedienfunktionen unterscheiden. Es kommt also - im Gegensatz zur "ODER"-Verknüpfung der Sensoren 2b, 2c beim "Verriegeln" - nunmehr darauf an, dass beide Sensoren 2b, 2c im Sinne einer "UND"-Verknüpfung baufschlagt werden, und zwar zeitlich hintereinander.

So folgt aus einem "Vorbeistreichen" der Hand 5 entlang der dem Kraftfahrzeug abgewandten Seite 4 beispielsweise von links nach rechts, bei welchem zunächst der Sensor 2b und dann der Sensor 2c ausgelöst werden, die Bedienfunktion "Komfortöffnen". Das ist in Fig. 3 dargestellt. Dagegen initiiert ein "Vorbeistreichen" in entgegengesetzter Richtung (erst Sensor 2c und dann Sensor 2b) die Komfortfunktion "Komfortschließen", wie dies in Fig. 4 gezeigt ist. Selbstverständlich kann dieses "Vorbeistreichen" mit einem von der Auswerteschaltung 6 vorgegebenen zeitfenster flankiert werden, nach dessen Ablauf ein oder beide Sensoren 2b, 2c wirkungslos geschaltet werden.

Die Auswerteschaltung 6 stellt sicher, dass die zuvor erläuterten jeweiligen Beaufschlagungsroutinen unterschieden werden können. Gleichzeitig sorgt die Auswerteschaltung 6 dafür, dass in Abhängigkeit von dem jeweiligen Signal eines Sensors 2a, 2b, 2c die jeweils nicht ausgelösten Sensoren 2a, 2b, 2c mit oder ohne zeitverzögerung vorgegebener Größe wirkungslos geschaltet werden. Natürlich unterstützt die Auswerteschaltung 6 auch die jeweils gewünschte Bedienfunktion und gibt ein entsprechendes Signal beispielsweise an eine zentrale Steueranlage bzw, die kraftfahrzeugseitige Sende-/Empfangseinheit ab.

Schließlich gibt die Auswertschaltung 6 die Detektionsbereiche 7a, 8 und Auslösebereiche 8, 9 vor. Das alles wird durch eine hintergelegte Software erreicht.

Die Sensoren 2a, 2b, 2c sind an exponierter Stelle außenseitig des Kraftfahrzeuges im Türaußengriff 1 angeordnet, lassen sich grundsätzlich aber auch in einem Außenspiegel, einem Blinkergehäuse etc. unterbringen. Im Rahmen des Ausführungsbeispiels handelt es sich bei dem Sensor 2a um einen Näherungssensor, also einen solchen, dessen Detektionsbereich 7a sich mit dem Auslösebereich 7b deckt. Das heißt, das Eindringen der Hand 5 in den Detektionsbereich 7a hat unmittelbar zur Folge, dass entsprechende Bedienfunktionen eingeleitet werden.

Dagegen sind die übrigen Sensoren 2b und 2c vorzugsweise als Berührungssensoren ausgeführt, bei denen der Auslösebereich 9 nur einen (geringen) Teilbereich des Detektionsbereiches 8 einnimmt. Das heißt, bei diesen Sensoren 2b, 2c kann ausdrücklich zwischen einem Annähern unterschieden werden (das zur Deaktivierung des Einzelsensors 2a führt) und dem eigentlichen Auslösen der Sensoren 2b, 2c, aus welchem dann die gewünschten Bedienfunktionen resultieren.

In der Figur 8 ist eine erfindungsgemäße Betätigungseinrichtung für Kraftfahrzeuge dargestellt mit einem türaußengriff 1, welcher in seinem Innern Einzelsettisoren 2a, 2b, 2d aufnimmt. Dabei ist der Sensor 2b mit zwei miteinander verbundene Sensorflächen zur jeweiligen Betätigung des Sensors ausgeführt. Bei den anderen beiden Sensoren handelt es sich um einen Einzelsensor 2a, der mit dem in den Figuren 1 bis 7 beschriebenen Sensor 2a übereinstimmen soll, und um einen Einzelsensor 2d.

Der Sensor 2b mit den zwei Sensorflächen ist als Berührungssensor ausgeführt, der bei Berührung einer der Sensorflächen einen Frage-/Antwortdialog zwischen einer nicht ausdrücklich dargestellten kraftfahrzeugseitigen Sende-/Empfangseinheit sowie einem bedienerseitigen Datenträger auslöst. Nach positivem Vergleich der auf dem Datenträger abgelegten nutzerspezifischen Daten und dem in der kraftfahrzeugseitigen Sende-/Empfangseinheit hinterlegten Code wird ein Signal an die Zentralverriegelung weitergegeben, die Kraftfahrzeugtürverschlüsse in diesem Fall zu verriegeln. Eine kurzzeitige Betätigung des Sensors 2d, der in diesem Ausführungsbeispiel als Berührungssensor ausgeführt ist, löst ebenfalls den beschriebenen Frage-/Antwortdialog und bei Berechtigung das anschließende verriegeln des Kraftfahrzeugtürschlosses aus. Durch diese Bedienfunktionen wird ein sicheres und schnelles Verriegeln des Kraftfahrzeugtürschlosses beim Berühren von annähernd der gesamten Vorderseite des Türaußengriffes 1 erreicht.

Zum Betätigen der Funktion "Komfortschließen" ist eine Berührung des Sensors 2d für einen definierten Zeitraum, vorzugsweise für 2 s, wie mit der Hand 5 dargestellt, erforderlich. Dieser Vorgang initiiert den beschriebenen Frage-/Antwortdialog und bei Berechtigung das anschließende "Komfortschließen". Durch diese Bedienfunktion kann ein versehentliches Auslösen der Funktion "Komfortschließen" nahezu ausgeschlossen werden.
Eine gleichzeitige Betätigung des Sensors 2d und einer oder beider Sensorflächen des Sensors 2b wird durch die Auswerteschaltung 6 als nicht eindeutiger Befehl zum "Komfortschließen" gewertet und löst nach erfolgreichem Frage-/Antwortdialog lediglich das anschließende Verriegeln des Kraftfahrzeugtürschlosses aus.

## Patentansprüche

1. Schlüssellose Sicherheits-/Betätigungseinrichtung für Kraftfahrzeuge, mit einer kraftfahrzeugseitigen Sende-/Empfangseinheit sowie einem bedienerseitigen Datenträger, und mit zumindest einem Sensor (2a, 2b, 2c, 2d), welcher einen Dialog zwischen der Sende-/Empfangseinheit und dem Datenträger zur Darstellung von Bedienfunktionen initiiert und zwei oder mehr Sensoren (2a, 2b, 2c, 2d) vorgesehen sind, welche je nach dem Zeitmuster ihrer Beaufschlagung unterschiedliche Bedienfunktionen einleiten, **dadurch gekennzeichnet, dass** wenigstens drei Sensoren (2a, 2b, 2c, 2d) vorgesehen sind, von denen zwei Sensoren (2b, 2c) als Koppelsensoren (2b, 2c) eine Betätigungseinheit (2b, 2c) formen, während die anderen Sensoren (2a, 2d) Einzelsensoren (2a, 2d) darstellen oder drei Sensoren (2a, 2b, 2d) als Einzelsensoren vorgesehen sind, von denen ein Sensor (2b) aus zwei miteinander verbundenen Sensorflächen besteht.

2. Sichdrheits-/Betätigungseinrichtung für Kraftfahrzeuge, mit einer kraftfahrzeugseitigen Sende-/Empfangseinheit sowie einem bedienerseitigen Datenträger und mit zumindest einem Sensor (2a, 2b, 2c, 2d), welcher einen Dialog zwischen der Sende-/Empfangseinheit und dem Datenträger zur Darstellung von Bedienfunktionen initiiert, **dadurch gekennzeichnet, dass** wenigstens drei Sensoren (2a, 2b, 2c, 2d) vorgesehen sind, wobei im Anschluss an die Beaufschlagung des einen Sensors (2b, 2c, 2d) der andere Sensor (2a) unmittelbar oder mit einstellbarer Verzögerung wirkungslos geschaltet wird.

3. Sicherheits-/Betätigungseinrichtung nach Anspruch 1 oder 2, **dadurch gekennzeichnet, dass** es sich bei den Sensoren (2a, 2b, 2c, 2d) um kapazitive Sensoren (2a, 2b, 2c, 2d), insbesondere Näherungssensoren (2a) und/oder Berührungssensoren (2b, 2c, 2d) handelt.

4. Sicherheits-/Betätigungseinrichtung nach einem der Ansprüche 1 bis 3, **dadurch gekennzeichnet, dass** die beiden Sensoren (2b, 2c) alternativ zur Darstellung einer oder mehrerer gewünschter Bedienfunktionen beaufschlagbar sind.

5. Sicherheits-/Betätigungseinrichtung nach einem der Ansprüche 1 bis 4, **dadurch gekennzeichnet, dass** die Sensoren (2b, 2c, 2d) gemeinsam und zeitlich hintereinander oder gleichzeitig zur Realisierung verschiedener Bedienfunktionen beaufschlagbar sind.

6. Sicherheits-/Betätigungseinrichtung nach einem der Ansprüche 1 bis 5, **dadurch gekennzeichnet, dass** je nach Abfolge der Beaufschlagung der beiden Sensoren (2b, 2c) zwischen unterschiedlichen Bedienfunktionen unterschieden werden kann.

7. Sicherheits-/Betätigungseinrichtung nach einem der Ansprüche bis 6, **dadurch gekennzeichnet, dass** die Sensoren (2a, 2b, 2c, 2d) an eine Auswerteschaltung (6) angeschlossen sind, welche zwischen jeweiligen Beaufschlagungsroutinen unterscheidet und gegebenenfalls in Abhängigkeit hiervon wenigstens einen Sensor (2a) mit oder ohne Zeitverzögerung vorgegebener Größe wirkungslos schaltet und/oder die jeweils gewünschte Bedienfunktion unterstützt.

8. Sicherheits-/Betätigungseinrichtung nach einem der Ansprüche 1 bis 7, **dadurch gekennzeichnet, dass** die Sensoren (2a, 2b, 2c, 2d) an exponierter Stelle außenseitig des Kraftfahrzeuges, beispielsweise im oder am Türaußengriff (1), angeordnet sind.

9. Sicherheits-/Betätigungseinrichtung nach einem der Ansprüche 1 bis 8, **dadurch gekennzeichnet, dass** die Sensoren (2a, 2b, 2c, 2d) einen regelmäßig von der Auswerteschaltung (6) vorgegebenen Detektionsbereich (7a, 8) und/oder Auslösebereich (7b, 9) aufweisen.

## Claims

1. Keyless security/operating device for motor vehicles, comprising a transmitting/receiving unit on the vehicle side as well as a storage medium on the operator side, and at least one sensor (2a, 2b, 2c, 2d), initiating a dialogue between the transmitting/receiving unit and the storage medium to represent operating functions and two or more sensors (2a, 2b, 2c, 2d), which depending on the time pattern of their activation trigger different operating functions, **characterized in that** at least three sensors (2a, 2b, 2c, 2d) are provided, of which two sensors (2b, 2c) are coupled sensors (2b, 2c) and form an operating unit (2b, 2c), whilst the other sensors (2a, 2d) represent individual sensors (2a, 2d) or three sensors (2a, 2b, 2d) are provided as individual sensors, of which one sensor (2b) consists of two connected sensor surfaces.

2. Security/operating device for motor vehicles, comprising a transmitting/receiving unit on the vehicle side as well as a storage medium on the operator side, and at least one sensor (2a, 2b, 2c, 2d), initiating a dialogue between the transmitting/receiving unit and the storage medium to represent operating functions, **characterized in that** at least three sensors (2a, 2b, 2c, 2d) are provided, in which after one of the sensors (2b, 2c, 2d) has been activated, the other sensor (2a) is rendered ineffective either immediately or after a settable delay.

3. Security/operating device according to claim 1 or 2, **characterized in that** the sensors (2a, 2b, 2c, 2d) are capacitive sensors (2a, 2b, 2c, 2d), in particular proximity sensors (2a) and/or tactile sensors (2b, 2c, 2d).

4. Security/operating device according to one of the claims 1 to 3, **characterized in that** the two sensors (2b, 2c) can be activated alternatively to represent one or several desired operating functions.

5. Security/operating device according to one of the claims 1 to 4, **characterized in that** the sensors (2b, 2c, 2d) can be activated together and one after the other or simultaneously for realizing different operating functions.

6. Security/operating device according to one of the claims 1 to 5, **characterized in that** depending on the activation sequence of the two sensors (2b, 2c) the different operating functions can be distinguished.

7. Security/operating device according to one of the claims 1 to 6, **characterized in that** the sensors (2a, 2b, 2c, 2d) are connected to an evaluating circuit (6) differentiating between the respective activation routines and which depending on these renders at least one of the sensors (2a) with or without a preset time delay ineffective, where applicable, and/or supports the respective desired operating function.

8. Security/operating device according to one of the claims 1 to 7, **characterized in that** the sensors (2a, 2b, 2c, 2d) are arranged at an exposed location on the outside of the motor vehicle, such as in or on the external door handle (1).

9. Security/operating device according to one of the claims 1 to 8, **characterized in that** the sensors (2a, 2b, 2c, 2d) contain a detection range (7a, 8) and/or activation range (7b, 9) regularly specified by the evaluating circuit (6).

## Revendications

1. Dispositif de sécurité / de commande sans clé pour véhicules avec une unité d'émission/réception côté véhicule ainsi qu'un support de données côté utilisateur et avec au moins un détecteur (2a, 2b, 2c, 2d) qui établit un dialogue entre l'unité d'émission/réception et le support de données pour représenter les fonctions de commande et sont prévus deux ou plus de détecteurs (2a, 2b, 2c, 2d) qui en fonction du type de durée de leur sollicitation, introduisent des fonctions de commande différentes **caractérisé en ce qu'**au moins trois détecteurs (2a, 2b, 2c, 2d) sont prévus dont deux détecteurs (2b, 2c) comme détecteurs couplés (2b, 2c) forment une unité de commande (2b, 2c)g alors que les autres détecteurs (2a, 2d) représentent des détecteurs individuels (2a, 2d) ou bien trois détecteurs (2a, 2b, 2d) sont prévus comme détecteurs individuels dont un détecteur (2b) se compose de deux surfaces de détecteur reliées entre elles.

2. Dispositif de sécurité / de commande pour véhicules avec une unité d'émission/réception côté véhicule ainsi qu'un support de données côté utilisateur et avec au moins un détecteur (2a, 2b, 2c, 2d) qui établit un dialogue entre l'unité d'émission/réception et le support de données pour représenter les fonctions de commande **caractérisé en ce qu'**au moins trois détecteurs (2a, 2b, 2c, 2d) sont prévus, à la suite de la sollicitation d'un détecteur (2b, 2c, 2d), l'autre détecteur (2a) étant désactivé directement ou avec temporisation paramétrée.

3. Dispositif de sécurité / de commande selon la revendication 1 ou 2 **caractérisé en ce que** les détecteurs (2a, 2b, 2c, 2d) sont des détecteurs (2a, 2b, 2c, 2d) capacitifs, en particulier des détecteurs de proximité (2a) et/ou des détecteurs de contact (2b, 2c, 2d).

4. Dispositif de sécurité / de commande selon l'une des revendications 1 à 3 **caractérisé en ce que** les deux détecteurs (2b, 2c) peuvent être sollicités alternativement pour représenter une ou plusieurs fonctions de commande souhaitées.

5. Dispositif de sécurité / de commande selon l'une des revendications 1 à 4 **caractérisé en ce que** les détecteurs (2b, 2c, 2d) peuvent être sollicités ensemble et l'un après l'autre dans le temps ou en même temps pour réaliser différentes fonctions de commande.

6. Dispositif de sécurité / de commande selon l'une des revendications 1 à 5 **caractérisé en ce qu'**en fonction de la chronologie de la sollicitation des deux détecteurs (2b, 2c) entre différentes fonctions de commande, il peut y avoir des différences.

7. Dispositif de sécurité / de commande selon l'une des revendications 1 à 6 **caractérisé en ce que** les détecteurs (2a, 2b, 2c, 2d) sont associés à une commutation d'évaluation (6) qui différencie entre les routines de sollicitation respectives et désactivant en fonction de cela le cas échéant au moins un détecteur (2a) avec ou sans temporisation d'une durée donnée et/ou soutenant la fonction de commande respectivement souhaitée.

8. Dispositif de sécurité / de commande selon l'une des revendications 1 à 7 **caractérisé en ce que** les détecteurs (2a, 2b, 2c, 2d) sont disposés à un endroit exposé côté extérieur du véhicule, par exemple dans et sur la poignée extérieure de porte (1).

9. Dispositif de sécurité / de commande selon l'une des revendications 1 à 8 **caractérisé en ce que** les détecteurs (2a, 2b, 2c, 2d) présentent une zone de détection (7a, 8) et/ou une zone de déclenchement (7b, 9) prescrite régulièrement de la commutation d'évaluation (6)
